Europäisches Patentamt

European Patent Office

Office européen des brevets

(11) Publication number: **0 138 550**
A2

# EUROPEAN PATENT APPLICATION

(21) Application number: 84306859.4

(22) Date of filing: 09.10.84

(51) Int. Cl.⁴: **H 03 M 1/68**, H 03 M 1/80

(30) Priority: 11.10.83 US 540231

(43) Date of publication of application: 24.04.85
Bulletin 85/17

(84) Designated Contracting States: DE FR GB IT

(71) Applicant: SPERRY CORPORATION, 1290, Avenue of the Americas, New York, N.Y. 10019 (US)

(72) Inventor: Dettmer, Jay Roland, 9634 Green Moon Path, Columbia Maryland 21046 (US)
Inventor: Haughey, Francis Bradford, 1438 West Marrow Drive, Phoenix Arizona 85027 (US)

(74) Representative: Singleton, Jeffrey et al, ERIC POTTER & CLARKSON 27 South Street, Reading Berkshire, RG1 4QU (GB)

(54) Resolution extender for integrated circuit digital-to-analogue converter.

(57) A high performance integrated circuit digital-to-analogue converter (10) is extended in resolution by the addition of one or more switchable current sources (15, 16) responsive to the least significant bits of the input digital number signal to be converted for providing binary weighted currents which are combined with the output of the integrated circuit digital-to-analogue converter to provide a higher performance, high resolution converter at minimal cost.

RESOLUTION EXTENDER FOR INTEGRATED CIRCUIT
DIGITAL-TO-ANALOGUE CONVERTER

The invention relates to the field of digital-to-analogue conversion.

High performance integrated circuit digital-to-analogue converters are commercially available that are substantially free from output anomalies (low glitch energy), have a low noise level and a low non-linearity error, provide fast settling time and are monotonic. Generally, as the resolution (number of input bits) of such converters is increased, the cost increases inordinately. For example, a twelve-bit high performance integrated circuit digital-to-analogue converter may cost three to five times as much as a ten-bit converter with the same high performance characteristics.

Stroke symbol generator displays usually require high performance digital-to-analogue converters to provide the cathode ray tube deflection signals. Such a stroke symbol generator is disclosed in Applicants' copending European Patent Application No.83.303447.3. In such a display system, the deflection digital-to-analogue converters are selected with a resolution which eliminates quantisation distortion when drawing shallow angled lines. This phenomenon is known as "stair stepping". The resolution of the converter should be such that the least significant converter bit provides a deflection significantly less than the cathode ray tube beam width. Generally, a resolution which provides a least significant bit deflection of approximately 6 percent of the typical beam width will eliminate visual stair stepping. In the stroke generation display system of the above mentioned copending patent application twelve bits of digital-to-analogue conversion resolution is required to eliminate the stair stepping phenomenon and this resolution is generally optimum in such cathode ray tube displays.

Thus, in the prior art, the high cost attendant to the utilisation of high performance and high resolution digital-to-analogue converters was necessarily suffered.

The above disadvantages of the prior art are overcome by the integrated circuit digital-to-analogue converter resolution extender of the present invention which comprises an integrated circuit digital-to-analogue converter coupled to receive the most significant portion of a digital number signal for providing an analogue signal proportional thereto, an extender circuit responsive to the least significant portion of the digital number signal to provide an analogue signal proportional thereto, and means for combining the analaogue signal from the integrated circuit converter and the analogue signal from the extender circuit to provide a combined analogue signal proportional to the digital input number.

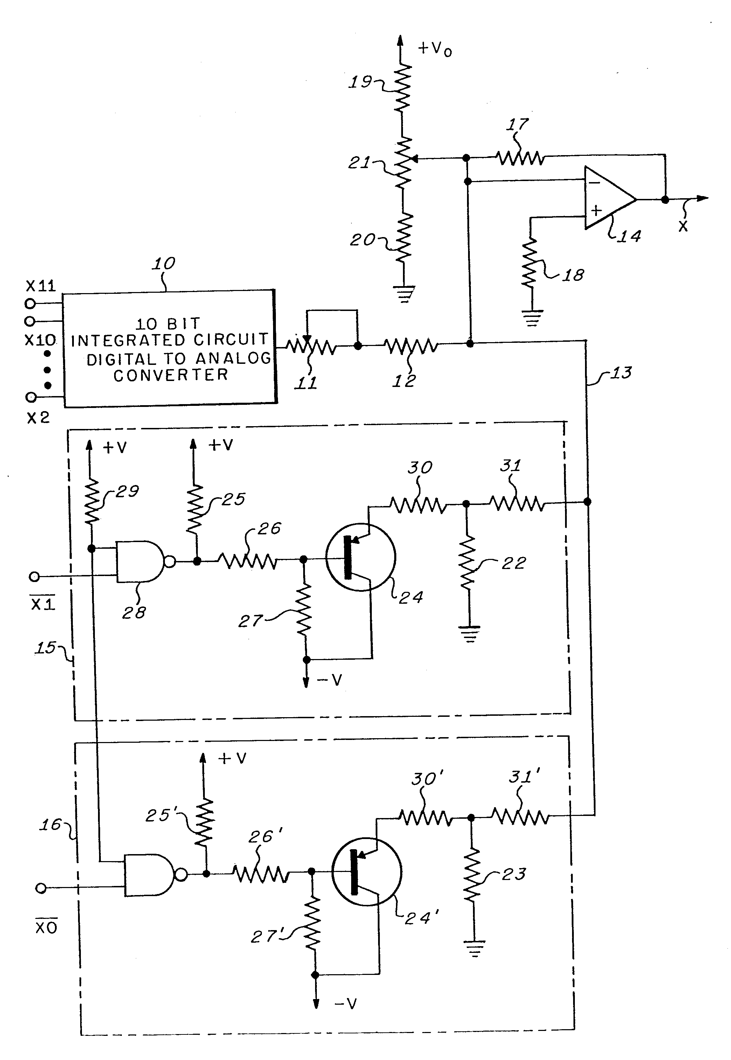

The invention will now be described in greater detail, by way of example, with reference to the accompanying sole figure of drawings which shows a schematic diagram of a preferred embodiment of the integrated circuit digital-to-analogue converter resolution extender of the present invention.

The present invention will be described in terms of extending the resolution of a ten-bit integrated circuit digital-to-analogue converter by two additional lower significant resolution bits to provide twelve bits of resolution. It will be appreciated that this arrangement is merely exemplary, other distributions of bits between the integrated circuit and the extender being within the scope of the invention. Generally, the resolution of an integrated circuit digital-to-analogue converter will be extended between one and four bits.

Referring to the sole figure of drawings, a twelve bit binary number comprising bits X0 through X11 is converted to an analogue signal X. The binary number may represent the digital X-deflection desired in a stroke symbol generator display and the corresponding analogue voltage X may provide the X-deflection signal for the cathode ray tube of the display system. In the preferred embodiment of the invention, the ten most significant bits of the

0138550

input binary number are applied to a ten-bit high performance integrated circuit digital-to-analogue converter 10. The converter 10 is preferably a monolithic converter which is commercially obtainable, for example from TRW as the TDC 1016J-10 converter. The output of the integrated circuit converter 10 is applied through a gain trimming potentiometer 11 and a gain adjusting resistor 12 to a summing junction 13 of an operational amplifier 14. The output of the operational amplifier 14 provides the analogue voltage X. The resistors 11 and 12 adjust the gain of the integrated circuit converter 10 to be commensurate with the gain of the extender circuit in a manner to be described.

The two least significant bits of the input binary number are applied to switchable current sources 15 and 16, respectively, whose outputs are in turn connected to the summing junction 13. The switchable current source 15 is configured to provide approximately one-half of the current provided by the least significant bit of the integrated circuit converter 10 and the switchable current source 16 is configured to provide approximately one-half of the current provided by the current source 15. When bit X1 of the input binary number is false, the current source 15 is switched on and when the least significant bit X0 is false, the current source 16 is switched on. When either of these bits are in the logical true state, the associated current source is switched off. The gain of the integrated circuit converter 10 is adjusted by the resistor 12 and trimmed by the potentiometer 11 to achieve the binary weighted relationship described between the converter 10 and the current sources 15 and 16.

The currents provided by the converter 10 and the sources 15 and 16 are summed at the summing junction 13 and applied to the inverting input of the operational amplifier 14. A resistor 17 provides feedback around the operational amplifier 14 and the non-inverting input thereof is connected to ground via a resistor 18. The value of the resistor 17 is selected to equal the nominal D.C. resistance to ground of the summing junction 13.

The potential at the summing junction 13 may be offset by an offsetting circuit comprised of resistors 19 and 20 and an offset trim potentiometer 21. If the integrated circuit digital-to-analogue converter 10 is of the unipolar variety which provides an output which swings between ground and a negative potential, the voltage on the summing junction 13 may be offset by the voltage dividing resistors 19 and 20 and trimmed by the potentiometer 21 to swing positively and negatively with respect to ground as is generally required for cathode ray tube deflection amplifier input signals. The offsetting of the signal at the summing junction 13 is effected by an offsetting voltage $+V_O$ applied to the resistor 19.

As previously described, the switchable current source 15 provides a current in response to the false state of the X1 bit which is approximately one-half of the current provided by the least significant bit of the integrated circuit converter 10. Similarly, the switchable current source 16 provides approximately one-half of the current provided by the source 15 in response to the false state of the X0 bit. This is achieved by configuring the current sources 15 and 16 identical to each other except for the values of shunting resistors 22 and 23 where the shunting resistor 22 has approximately twice the resistance of the shunting resistor 23. The remainder of the current source 15 will now be described, it being appreciated that the same description applies to the identically configured portions of the current source 16.

A transistor 24 is biased into non-conduction by the +V and -V power supply connections across a voltage divider comprised of resistors 25, 26 and 27. A NAND gate 28 turns on the transistor 24 when the X1 bit is false. When the X1 bit is true, the transistor 24 is rendered non-conductive. The NAND gate 28 is illustrated as a two-input gate, one input receiving a logical signal of +V via a resistor 29. The current source 15 further includes resistors 30 and 31 which, together with the resistor 22, form a current divider network for providing the appropriate binary weighted current to the summing junction 13.

In a preferred embodiment of the invention, each of the NAND gates 28 and 28' may be of the open collector variety, such as a 54LS26 gate. Thus, when X1 is high and therefore $\overline{X1}$ is low, the gate 28 is switched to its open collector condition. The resistance values of resistors 25, 26 and 27 are selected so that the base of the transistor 24 is at ground potential when the gate 28 is in its open collector state. Thus, the transistor 24 under these conditions is off and current is not contributed to the summing junction 13. Conversely, when X1 is low and $\overline{X1}$ is high, the gate 28 is turned on thereby grounding the output thereof resulting in a negative turn-on potential applied to the base of the transistor 24. Conveniently, the transistors 24 and 24' may be 2N2907A transistors and the operational amplifier 14 may be a LM118 amplifier.

In the preferred embodiment, the resistance values of resistors 11, 12, 17-23, 25-27 and 29-31 have respective resistance values in ohms of 500, 953, 5.62K, 820, 4.02K, 4.02K, 1K, 33.2 16.5, 1K, 1K, 2K, 10K, 1K and 61.9K. It will be appreciated that the resistors having primed reference numerals associated therewith have the same resistance values as the resistors having corresponding unprimed reference numerals associated therewith.

In the specific embodiment discussed, the offset voltage $+V_0$ is +6.2 volts and the voltages designated as +V and -V are +5 and -5 volts, respectively.

Thus, it will be appreciated that since the 33.2 ohm value for the resistor 22 is approximately twice that of the 16.5 ohm resistor 23, the current source 15 provides approximately twice the current of the current source 16. It will be further appreciated that all points throughout the circuitry utilised for the two least significant bits have a relatively low impedance to ground. This minimises any noise pick-up that might otherwise degrade the clarity of the display. The value of the feedback resistor 17 around the operational amplifier 14 is selected in accordance with display characteristics.

It will also be appreciated that it is not necessary for the extended least significant stages, in the stroke writing display environment described, to exhibit low glitch energy and low non-linearity error since anomalous contributions of these stages would not be visually perceptible. Since the primary function of the extended least significant bigs is to eliminate the stair stepping phenomenon by providing increased resolution and not to provide accurate positioning data, the extender stages need ogly exhibit low noise, fast settling time and monotonicity. These considerations also apply to other than stroke writing display environments such as digital audio systems.

Thus, the present invention couples a high performance integrated circuit digital-to-analogue converter with an extender to provide a high performance, low cost digital-to-analogue converter with noise an order of magnitude lower than the corresponding line widths stroked on the cathode ray tube display, with a low real estate requirement and without any sacrifice in display quality. The noise, glitch energy and non-linearity of the extended least significant bits are of such low magnitude as to be imperceivable when displaying cathode ray tube graphics. The resolution requirement of the high performance integrated circuit digital-to-analogue converter is reduced by the number of bits of the extender so as to effect a significant reduction in cost. The expense of the discrete components utilised to implement the extender is insignificant compared to the cost of the integrated circuit digital-to-analogue converter.

Thus, in the specific embodiment described, the ten-bit integrated circuit digital-to-analogue converter is extended to a twelve-bit converter by the addition of the discrete component circuitry to provide a high performance twelve-bit converter that otherwise would have cost three to five times that of the ten-bit converter.

Claims

1. An integrated circuit digital-to-analogue converter resolution extender, characterised in that it comprises an integrated circuit digital-to-analogue converter (10) coupled to receive the most significant portion of a digital number signal for providing a first analogue signal proportional thereto, extender circuit means (15,16) responsive to the least significant portion of the digital number signal to provide a second analogue signal proportional thereto, and means (14) for combining the first and second analogue signals to provide a combined analogue signal proportional to the digital input number.

2. Apparatus according to Claim 1, characterised in that the extender circuit means comprises a switchable current source (15,16) for each bit of the least significant portion of the digital number signal activated by the bit associated therewith, the current source associated with the most significant bit of the least significant portion providing a current of approximately one-half the current provided by the least significant stage of the integrated circuit digital-to-analogue converter (10).

3. Apparatus according to Claim 2, characterised in that the extender circuit means comprises two switchable current sources (15,16) each having low impedance shunt resistance means (22,23) such that the impedance of the shunt resistance means (23) of the switchable current source (16) associated with the first least significant bit of the least significant portion of the digital number signal is approximately one-half the impedance of the shunt resistance means (22) of the switchable current source (15) associated with the second least significant bit of the least significant portion.

4. Apparatus according to claim 2 or 3, characterised in that the or each switchable current source (15,16) includes a transistor (24,24') and a logic gate (28) for activating the transistor, the logic gate being coupled to receive the associated bit of the least significant portion of the digital number signal, with the logic gate activating or deactivating the transistor in accordance with the state of the associated bit.

5. Apparatus according to Claim 4, characterised in that the logic gate (28) comprises an open collector-type NAND gate.

6. Apparatus according to any of the preceding claims, characterised in that the combining means comprises a summing junction (13) coupled to receive the first and second analogue signals, and an operational amplifier circuit (14) with an input coupled to the summing junction.

0138550